# EUROPEAN PATENT SPECIFICATION

(11) **EP 1 026 730 B1**
(45) Date of publication and mention of the grant of the patent: **13.12.2006**
(21) Application number: 00480019.9
(22) Date of filing: 03.02.2000
(51) Int. Cl.: H01L 21/285, C23C 26/00, C23C 10/00, C30B 1/02

(54) **A method to form uniform silicide features**
Methode, einheitliche Silizidbereiche herzustellen
Méthode de fabrication des regions en siliciure uniforme

(30) Priority: 05.02.1999 US 245994
(43) Date of publication of application: 09.08.2000
(73) Proprietor: Chartered Semiconductor Manufacturing Pte Ltd., Singapore 738406 (SG)
(72) Inventor: Chan, Lap, San Francisco, CA 94109 (US); Sing Ho, Chaw, Singapore 470422 (SG); Sam Li, Fong Yau, Singapore 470422 (SG); Ng, Hou Tee, Singapore 531006 (SG)
(74) Representative: Schuffenecker, Thierry

(56) References cited:
- US-A- 5 075 243
- ANONYMOUS: "Direct Pattern Writing by Local Heating in a Scanning Tunneling Microscope" IBM TECHNICAL DISCLOSURE BULLETIN, vol. 29, no. 6, 1 November 1986 (1986-11-01), pages 2680-2681, XP002262766 New York, US
- GORWADKAR S ET AL: "ATOMIC FORCE MICROSCOPE PATTERNING ON PLASMA DEPOSITED POLYACETYLENE FILM" JOURNAL OF APPLIED PHYSICS, AMERICAN INSTITUTE OF PHYSICS. NEW YORK, US, vol. 78, no. 4, 15 August 1995 (1995-08-15), pages 2242-2247, XP000541313 ISSN: 0021-8979
- "PULSED CURRENT PYROLYSIS FOR BOTH CIRCUIT REPAIR AND CIRCUIT MODIFICATION" IBM TECHNICAL DISCLOSURE BULLETIN, IBM CORP. NEW YORK, US, vol. 34, no. 12, 1 May 1992 (1992-05-01), page 91 XP000308440 ISSN: 0018-8689

## Description

### Technical field

The invention relates to the fabrication of integrated circuit devices, and more particularly, to a method of forming uniform ultrathin silicide features in the fabrication of integrated circuits.

### Background art

In the fabrication of integrated circuits, the fabrication of ultrathin uniform silicide layers on sub 0.1 micron features is expected to be extremely difficult using the standard salicide (self-aligned silicide) process. A key problem is the interfacial non-uniformity as the silicide thickness is scaled down from about 100 nm (1000 Angstroms) to about 30 nm (300 Angstroms). This non-uniformity issue of ultrathin silicide films is mainly related to the statistical nature of the nucleation events required to form the resulting low-resistivity phase, as well as the non-uniformity of the existing rapid thermal annealing (RTA) process.

U. S. Patent 5,712,191 to Nakajima et al teaches spin coating a nickel acetate solution onto a silicon layer and heat treating at 300-500 °C to form nickel silicide. A laser light is then irradiated to promote crystal growth in the area of the nickel silicide. However, laser irradiation or modification may not allow features smaller than submicron scale to be fabricated. Laser irradiation only allows a single localized modification at any one time. Additionally, laser irradiation has been observed experimentally to induce cracks and film peelings due to the large thermal shock induced in the localized nickel oxide regions at any one time within an extremely short time period. U.S. Patent 5,510,295 to Cabral, Jr. et al teaches depositing a cobalt layer over silicon, annealing the cobalt layer at 900-1000 °C in a N₂ ambient, then depositing a titanium layer thereover and annealing to form titanium silicide. U.S. Patent 4,908,334 to Zuhr et at forms a silicide film by ion beam deposition of metal onto silicon at 400-600 °C. U.S. Patent 5,728,625 to Tung discloses growing cobalt silicide on silicon in ultra-high vacuum and growing cobalt on silicon and then annealing at 450-800 °C to form cobalt silicide. U.S. Patent 5,702,972 to Tsai et al teaches depositing titanium onto silicide to form titanium silicide and then annealing to change the titanium silicide from phase C49 to phase C54. U.S. Patent 4,957,777 to Ilderem et al teaches depositing titanium silicide over polysilicon using silane.

IBM Technical disclosure Bulletin (01-11-86), 29(6), 2680-2681 discloses a Scanning Tunneling Microscope used for locally forming metal silicide features , but does not disclose deposition of a metal acetate layer and transforming portions of the metal acetate layer to a metal silicide.

The document "ATOMIC FORCE MICROSCOPE PATTERNING ON PLASMA DEPOSITED POLYACETYLENE FILM" , by S GORWADKAR ET AL, Journal of Applied Physics, American Institute of Physics, New York, US, , (15-08-1995), 78(4), 2242-2247 discloses a process for patterning a layer using an Atomic Force Microscope (AFM), and metallic (AFM) tip.

IBM Technical disclosure Bulletin 34(12), 91 (01-05-1992) discloses localised heating of Pd acetate using a scanned focused laser beam for locally forming a metallic strip.

### Summary of the invention

A principal object of the present invention is to provide an effective and very manufacturable method of fabricating a uniform silicide film in the fabrication of an integrated circuit.

A further object of the invention is to provide a method of fabricating uniform ultrathin silicide features in the fabrication of an integrated circuit.

Yet another object is to provide a method of forming uniform silicide features having a spatial width of 0.1 microns and below.

Yet another object is to provide a method of localized and uniform formation of silicide.

Yet another object of the invention is to provide a method for uniform formation of silicide utilizing a cost-effective precursor for silicide formation.

A still further object of the invention is to provide a method for uniform formation of silicide wherein oxidation of a metallic oxide is avoided.

In accordance with the objects of the invention a method for forming uniform ultrathin silicide features in the fabrication of an integrated circuit is achieved as defined by claim 1.

A metal acetate layer is spin-coated over the surface of a silicon semiconductor substrate. An array of heated metallic tips contacts the metal acetate layer whereby the metal acetate layer is transformed to a metal silicide where the metallic tips contact the metal acetate layer and wherein the metal acetate layer not contacted by the metallic tips is unreacted. The unreacted metal acetate layer is removed leaving the metal silicide as the uniform ultrathin silicide features.

Also, following from the invention, a metal acetate layer is spin-coated over the surface of a silicon semiconductor substrate. An array of heated metallic tips contacts the metal acetate layer on polysilicon gates and diffusion regions whereby the metal acetate layer is transformed to a metal silicide where the metallic tips contact the metal acetate layer and wherein the metal acetate layer not contacted by the metallic tips is unreacted. The heating is performed in a H₂ or N₂ ambient under high vacuum to prevent oxidation of the metal surfaces. The unreacted metal acetate layer is removed leaving the metal silicide as the uniform ultrathin silicide features.

### Description of the drawings

In the accompanying drawings forming a material part of this description, there is shown:
Figs. 1 through 3 schematically illustrate in cross-sectional representation the preferred embodiment of the present invention.
Fig. 4 schematically illustrates in cross-sectional representation an example of a completed integrated circuit device fabricated by the process of the present invention.

### Description of the preferred embodiment

The present invention embodies one method for forming uniform ultrathin silicide features in the fabrication of an integrated circuit. The silicide features comprise titanium silicide, cobalt silicide, platinum silicide, tantalum silicide, nickel silicide, or palladium silicide and may have a spatial width of 100 nanometers (0.1 microns) or smaller. Alloy silicides of titanium, cobalt, platinum, tantalum, nickel, or palladium may also be used.

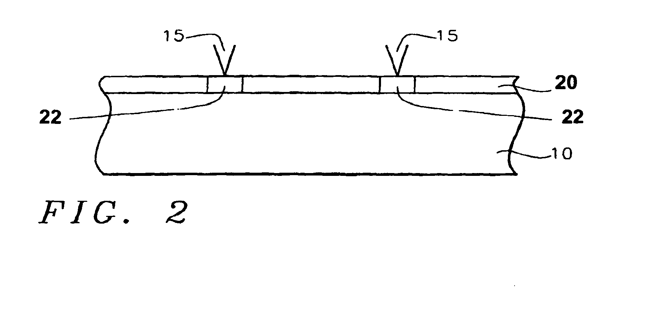

The embodiment of the present invention will now be described with reference to Figs. 1 through 3. Referring to Fig. 1, there is shown an illustration of a portion of a partially completed integrated circuit. The semiconductor substrate 10 is preferably composed of silicon having a (100) crystallographic orientation. The substrate may be an n- or p-type silicon.

An ultrathin film of cobalt acetate (Co(OA_{c})₂) 20 is deposited over the surface of the substrate by a spin-on method to a thickness of between about 0.05 and 0.2 microns (500 and 2000 Angstroms).

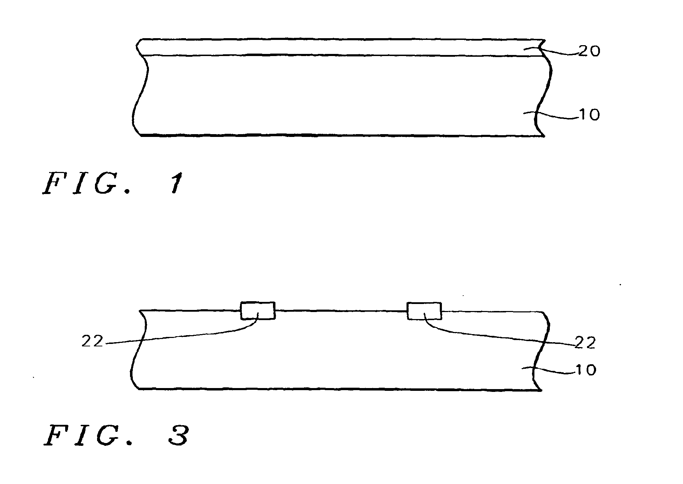

The cobalt acetate is subjected to a thermal treatment using the metallic tips 15 to transform it to cobalt at locations 22, as shown in Fig. 2 and 3.

Referring now to Fig. 2, an array of refractory metallic tips 15 made of platinum, tantalum, titanium, or a metal nitride is heated to a temperature of between about 500 and 1200 °C and placed in contact with the thin film 20 at specific locations where the silicide features are to be formed for between about 10 and 20 seconds. The heated metallic tips contacting the thin film causes localized formation of silicide 22. Lines and features may be formed by maneuvering of the metallic tips. The metallic tips are aligned and patterned according to the desired layout.

Each of the metallic tips may be connected to a resistance heating source to ramp them up to the desired temperature. The material used for the tips typically have melting points much higher than the temperature required; that is, nearly twice. The metallic tips typically have a radius of curvature of about 100 nanometers. Such tips are usually used at the atomic level to estimate surface morphology using a technique called atomic force microscopy (AFM) or scanning tunneling microscopy (STM).

The thermal treatment also comprises an atmosphere of H₂ or N₂ in a high vacuum or ultrahigh vacuum and a temperature of about 300 to 500 °C to less than about 900 °C. For example, high vacuum is between about 1.33 x 10⁻³ and 1.33 x 10⁻⁵ Pa (10⁻⁵ and 10⁻⁷ Torr) and ultrahigh vacuum is between about 1.33 x 10⁻⁸ and 1.33 x 10⁻⁹ Pa (10⁻¹⁰ and 10⁻¹¹ Torr). The thermal treatment forms cobalt silicide lines or features 22 on the silicon substrate without oxidation of the metal surfaces. The unreacted cobalt acetate film 20 is removed, for example using an organic solvent; e.g. ethanol, methanol, or isopropyl alcohol (IPA), leaving the metallic silicide features 22 on the silicon substrate , shown in figure 3 .

Alternatively, in the embodiment of the invention, nickel acetate, platinum acetate, or palladium acetate may be used in place of the cobalt acetate.

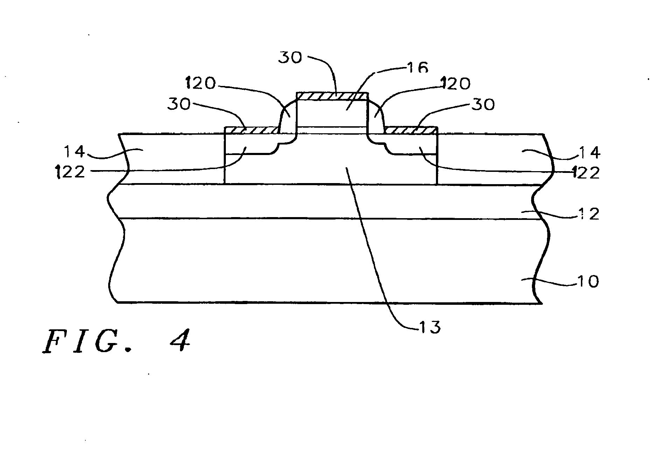

This formation of silicide features can be incorporated into a typical transistor process flow. For example, as shown in Fig. 4, a typical transistor fabrication process flow includes formation of shallow trench isolation 14, gate 16, sidewall spacers 120, and source/drain junctions 122. Subsequently, a thin layer of metal acetate is spin-coated. The metal acetate is transformed to metal silicide at specific areas according to the embodiment of the invention. Silicide 30 is formed, for example, on the gate 16 and over the source/drain regions 122.

The process of the invention is especially suited for fabricating ultrathin silicide films on silicon-on-insulator (SOI) substrates, as shown in Fig. 4 where silicon 13 has been formed overlying the insulating layer 12. The main advantage for SOI applications is that no substrate heating is required which reduces any additional thermal stress induced on the silicon channel 13 overlying the silicon dioxide layer 12.

## Claims

1. A method of fabricating silicide features in the manufacture of an integrated circuit device comprising:
spin-coating a metal acetate layer (20) over the surface of a silicon semiconductor substrate (10);
contacting said metal acetate layer (20) with an array of heated metallic tips (15) wherein said metallic tips are heated to a temperature of between 500 and 1200°C whereby said metal acetate layer is transformed to a metal silicide (22,30) where said metallic tips contact said metal acetate layer and wherein said metal acetate layer not contacted by said metallic tips is unreacted; and
thereafter removing said unreacted metal acetate layer (20) leaving said metal silicide as said silicide features in the manufacture of said integrated circuit device.

2. The method according to Claim 1 wherein said metal acetate layer comprises cobalt acetate and has a thickness of between 0.05 and 0.2 microns (500 and 2000 Angstroms).

3. The method according to Claim 1 wherein said metallic tips comprise one of the group containing platinum, tantalum, and titanium.

4. The method according to Claim 1 wherein said metallic tips comprise a refractory metal or a metal nitride.

5. The method according to Claim 1 further comprising subjecting said integrated circuit device to a H₂ or N₂ atmosphere at high vacuum of between 1.33 x 10⁻³ and 1.33 x 10⁻⁵ Pa (10⁻⁵ and 10⁻⁷ Torr) to a temperature of between 300 and 500 °C to less than about 900 °C.

6. The method according to Claim 1 further comprising subjecting said integrated circuit device to a H₂ or N₂ atmosphere at an ultrahigh vacuum of between 1.33 x 10⁻⁸ and 1.33 x 10⁻⁹ Pa (10⁻¹⁰ and 10⁻¹¹ Torr) to a temperature of between 300 and 500 °C to less than about 900°C.

7. The method according to claim 1 wherein said metal acetate layer (20) is contacted with said array of heated metallic tips (15) under vacuum whereby said metal acetate is not oxidized.

8. The method according to Claim 1 wherein said metal acetate layer comprises one of the group containing, platinum acetate, nickel acetate, tantalum acetate, and palladium acetate and has a thickness of between 0.05 and 0.2 microns (500 and 2000 Angstroms).

9. The method according to Claim 1 wherein said silicide features have a spatial width of less than 0.1 micron.

## Patentansprüche

1. Verfahren zum Herstellen von Silizidbereichen bei der Herstellung einer integrierten Schaltkreisvorrichtung aufweisend:
Rotationsbeschichten mit einer Metallacetatschicht (20) auf der Oberfläche eines Siliziumhalbleitersubstrats (10);
Kontaktieren besagter Metallacetatschicht (20) mit einem Bereich erhitzter, metallischer Spitzen (15), wobei besagte metallische Spitzen bis zu einer Temperatur zwischen 500 und 1200°C erhitzt sind, wobei besagte Metallacetatschicht in ein Metallsilizid (22, 30) umgewandelt wird, wo besagte metallische Spitzen besagte Metallacetatschicht kontaktieren, und wobei besagte Metallacetatschicht, die nicht von besagten metallischen Spitzen kontaktiert wird, nicht reagiert; und
nachfolgendem Entfernen besagter nicht reagierter Metallacetatschicht (20), unter Zurücklassen besagter Metallsilizide als besagte Silizidbereiche bei der Herstellung besagter integrierter Schaltkreisvorrichtung.

2. Verfahren nach Anspruch 1, wobei besagte Metallacetatschicht Kobaltacetat aufweist und eine Dicke von zwischen 0,05 und 0,2 µm (500 und 2000 Angström) hat.

3. Verfahren nach Anspruch 1, wobei besagte metallische Spitzen eines aus der Gruppe von Platin, Tantal und Titan aufweist.

4. Verfahren nach Anspruch 1, wobei besagte metallische Spitzen ein hitzebeständiges Metall oder ein Metallnitrid aufweist.

5. Verfahren nach Anspruch 1, ferner aufweisend das Unterwerfen besagter integrierter Schaltkreisvorrichtung einer H₂ oder N₂ Atmosphäre bei einem Hochvakuum von zwischen 1,33 x 10⁻³ und 1,33 x 10⁻⁵ Pa (10⁻⁵ und 10⁻⁷ Torr) bis zu einer Temperatur von zwischen 300 und 500°C bis weniger als 900°C.

6. Verfahren nach Anspruch 1, ferner aufweisend das Unterwerfen besagter integrierter Schaltkreisvorrichtung einer H₂ oder N₂ Atmosphäre bei einem Hochvakuum von zwischen 1,33 x 10⁻⁸ und 1,33 x 10⁻⁹ Pa (10⁻¹⁰ und 10⁻¹¹ Torr) bis zu einer Temperatur von zwischen 300 und 500°C bis weniger als 900°C.

7. Verfahren nach Anspruch 1, wobei besagte Metallacetatschicht (20) mit besagten Bereichen der erhitzten, metallischen Spitzen (15) unter Vakuum kontaktiert wird, wobei besagtes Metallacetat nicht oxidiert wird.

8. Verfahren nach Anspruch 1, wobei besagte Metallacetatschicht eines aus der Gruppe von Platinacetat, Nickelacetat, Tantalacetat und Palladiumacetat aufweist, und eine Dicke von zwischen 0,05 und 0,2 µm (500 bis 2000 Angström) hat.

9. Verfahren nach Anspruch 1, wobei besagte Silizidbereiche eine räumliche Breite von weniger als 0,1 µm haben.

## Revendications

1. Procédé de fabrication de régions en siliciure dans la fabrication d'un dispositif à circuit intégré comprenant les étapes consistant à :
appliquer par centrifugation une couche d'acétate de métal (20) sur la surface d'un substrat de semiconducteur en silicium (10) ;
faire contacter ladite couche d'acétate de métal (20) avec un arrangement de pointes métalliques chauffées (15) dans lequel lesdites pointes métalliques sont chauffées à une température entre 500 et 1 200° C moyennant quoi ladite couche d'acétate de métal est transformée en un siliciure métallique (22, 30), où lesdites pointes métalliques contactent ladite couche d'acétate de métal et dans lequel ladite couche d'acétate de métal non contactée par lesdites pointes métalliques est sans réaction ; et
retirer par la suite ladite couche d'acétate de métal sans réaction (20) laissant ledit siliciure métallique comme lesdites caractéristiques de siliciure dans la fabrication dudit dispositif à circuit intégré.

2. Procédé selon la revendication 1 dans lequel ladite couche d'acétate de métal comprend de l'acétate de cobalt et présente une épaisseur entre 0,05 et 0,2 micron (500 et 2 000 angströms).

3. Procédé selon la revendication 1 dans lequel lesdites pointes métalliques comprennent un élément parmi le groupe contenant du platine, du tantale et du titane.

4. Procédé selon la revendication 1 dans lequel lesdites pointes métalliques comprennent un métal réfractaire ou un nitrure de métal.

5. Procédé selon la revendication 1 comprenant en outre l'étape consistant à soumettre ledit dispositif à circuit intégré à une atmosphère de H₂ ou N₂ à un vide élevé entre 1,33 x 10⁻³ et 1,33 x 10⁻³ Pa (10⁻⁵ et 10⁻⁷ Torr) à une température entre 300 et 500° C à moins d'environ 900° C.

6. Procédé selon la revendication 1 comprenant en outre l'étape consistant à soumettre ledit dispositif à circuit intégré à une atmosphère de H₂ ou N₂ à un ultra-vide entre 1,33 x 10⁻⁸ et 1, 33 x 10⁻⁹ Pa (10⁻¹⁰ et 10⁻¹¹ Torr) à une température entre 300 et 500° C à moins d'environ 900° C.

7. Procédé selon la revendication 1 dans lequel ladite couche d'acétate de métal (20) est contactée par ledit arrangement de pointes métalliques chauffées (15) sous vide moyennant quoi ledit acétate de métal n'est pas oxydé.

8. Procédé selon la revendication 1 dans lequel ladite couche d'acétate de métal comprend un élément parmi le groupe contenant de l'acétate de platine, de l'acétate de nickel, de l'acétate de tantale et de l'acétate de palladium et présente une épaisseur entre 0,05 et 0,2 micron (500 et 2 000 angströms).

9. Procédé selon la revendication 1 dans lequel lesdites caractéristiques de siliciure présentent une largeur spatiale inférieure à 0,1 micron.
